# EUROPEAN PATENT APPLICATION

(11) **EP 1 235 152 A2**
(43) Date of publication of application: **28.08.2002**
(21) Application number: 01250334.8
(22) Date of filing: 21.09.2001
(51) Int. Cl.: G06F 11/26

(54) **Apparatus and method for in-circuit emulation using a high-level programming language**

(30) Priority: 27.02.2001 KR 2001009918
(71) Applicant: Korea Advanced Institute of Science and Technology, Taejon City 305-701 (KR)
(72) Inventor: Kyung, Chong Min, Yusung-gu, Taejon City 305-333 (KR); Park, Cheol, Yusung-gu, Taejong City 305-762 (KR); Lee, Seung Jong, Ilsan-gu, Kyang-City, Kyungki-do 411-372 (KR); Ki, An Do, Yusung-gu, Taejon City 305-333 (KR)
(74) Representative: Hengelhaupt, Jürgen D., Dipl.-Ing.

(57) **Abstract**

An in-circuit emulation method is provided which comprises an emulator, a host computer, and a target system, where the host computer compiles a software model of a target chip to a compiled code downloaded to the emulator that interacts with the target system by executing the compiled code. Specifically, the software model of target chip is described in a high-level programming language. The emulator includes two functional modules, a processing engine and a pin signal generator (PSG). The processing engine executes the compiled code and the PSG interacts with the target system after the PSG is configured as a number of functional blocks. Specifically, at least one of the functional blocks is configured in accordance with an external interface model in order to interact with the target system. A software conversion method is also provided which includes the steps of identifying I/O variables and translating them to the corresponding I/O functions.

## Description

The present invention in general relates to verifying logic functions through emulation. More specifically, the present invention relates to emulating the logic functions in chip design by describing them in a high-level programming language.

A successful design of a semiconductor chip ("chip") containing an integrated circuit requires ever-increasing efforts and time as the complexity of such chips and those systems integrating such chips increases drastically. Since it is desirable to eliminate the design errors in a design procedure before fabrication of such chips, verification of the logic design in chip design is widely adopted. Among various methods of verification is an emulation method that tries to verify the functional correctness of the logic function of a chip designed to be used in a target system.

Traditionally, verification of a logic function has been performed by software or hardware modeling or a combination of the two. Software modeling describes the behavior of the logic through software, in terms of either a high-level programming language such as C/C++ or a hardware description language (HDL) such as VHDL and Verilog. US Patent No.6,009,256 discloses a "SEmulation system," which allows specifying the structure and function of a circuit in an HDL and generates a software model or a hardware model of the circuit. US Patent No. 6,058,592 discloses a similar logic emulator based on an HDL.

However, as a logic design becomes increasingly complex, especially with the growth of System-on-a-Chip, it becomes crucial to reduce the amount of time needed for design and in-system verification of the logic. Emulation of the logic at an earlier stage of the logic design is preferable using a software programming language such as C or C++, which is easier to code and debug and runs faster compared to HDL.

After verification of the functional behavior of the logic as coupled to the surrounding hardware system or a target system, the logic may be partitioned manually or possibly with some automatic means into parts to be implemented as hardware and software, respectively. This approach would significantly save the design and verification time, compared to the conventional HDL-based emulation method.

US Patent No.4,901,259 discloses an "ASIC emulator" which enables models in software programming languages as well as those in HDL to be run on general-purpose computer connected to a target system via interface. It is basically a generalized pin I/O synchronizer receiving all the pin signals produced by software modeling while interface with external circuits are all performed by software modeling. The ASIC emulator system calculates pin signal values contained in the modeling, and then converts the pin signal values into electrical signals in order to send the values to a socket in the target system. Communication between the host computer and the ASIC emulator consists of a lot of pin signal values required for all pins.

However, when fast emulation is needed, "ASIC emulator" described in U.S. Patent No. 4,901,259 presents several problems. First, the software the host computer uses is slow to execute the whole process related to the generation of pin signals used for external interface part. Second, the communication speed through an I/O port of a full-fledged host computer is generally very slow as compared with a processor speed. Third, the host computer is slow to run the algorithm of the logic because it uses a general-purpose operating system that cannot dedicate its computing resource solely to running the algorithm.

There have been tools developed that automatically convert the C-described chip design into a register-transfer level (RTL) description. However, such tools have been used in testing complex chips such as application-specific integrated circuit (ASIC) in isolation. In other words, it has not been possible to verify a C-described chip as installed in a target system because verification of a chip along with its target system requires interface with a large variety of external devices depending on the target system.

Therefore, there still exists a need for an emulator that can provide a fast and effective emulation of a chip design described in a high-level programming language as C or C++, and that in conjunction with its target hardware system ("in-circuit") environment.

The present invention provides an apparatus and method for high-speed verification of a logic function in a chip design in conjunction with a desired target system during the very early stage of the chip design. In order to achieve the above-mentioned goal, the algorithmic behavior of the logic function is described in a high-level programming language such as C or C++. The algorithm of the logic function is then compiled in the host computer and downloaded to the emulator of the present invention.

The emulator of the present invention includes a processing engine module having at least one processor and a pin signal generator module having at least one programmable logic device, such as a field-programmable gate array or a programmable logic device. The processing engine module executes the compiled code of the algorithm described in a high-level programming language while the pin signal generator module generates pin signals compatible with the external interface of a target logic. The apparatus further comprises a monitoring or debugging block in order to provide a facility to observe the waveforms of the pin signals for a debugging or monitoring purpose.

The method of the present invention includes a chip design flow where input/output (I/O) variables are used to translate them into I/O functions. The I/O variables stand for those software variables in the algorithm performed by the chip requiring interaction with the target system. The I/O variables are translated to the corresponding I/O function thereby allowing the algorithm to invoke an external interface in a pin signal generator.

FIG. 1 is an overall block diagram of a circuit emulation system including the in-circuit emulator of present invention.

FIG. 2 is a block diagram of a processing engine for executing an internal logic function.

FIG. 3 is a block diagram of a pin signal generator (PSG) for generating pin signals for an external interface.

FIG. 4 is a block diagram of a decoder block as a part of the PSG.

FIG. 5 is a block diagram of an interrupt handler as a part of the PSG.

FIG. 6 is a block diagram of a debugging block as a part of the PSG.

FIG. 7 is a block diagram of an interface library block as a part of the PSG.

FIG. 8 is a flow diagram of the translation, compilation, and logic synthesizing processes, which includes generating the compiled code and net-list.

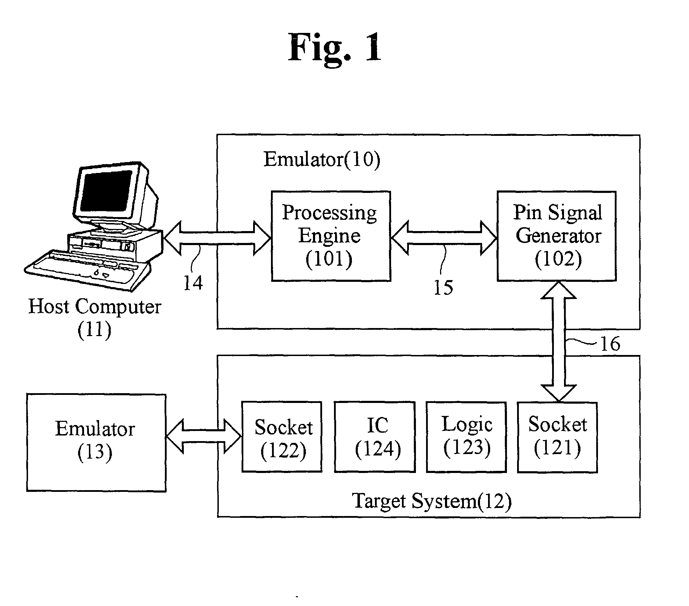

Fig. 1 shows an overview of an emulation environment of the present invention. The environment includes an emulator 10 that has a processing engine (PE) 101 and a pin signal generator (PSG) 102. The emulator communicates with a host computer 11, which compiles an algorithm written in a programming language such as C or C++ into a compiled code. The compiled code is then communicated to a memory of the emulator 10 (not explicitly shown in the Fig. 1) via a communication port 14. Any communication protocol or manner may be used for transferring the compiled code into the emulator 10.

The environment also includes a target system on which the designed chip will eventually be mounted. The target system 12 will typically include a socket 121 for communicating with the emulator 10, and other sockets 122 for communicating with another emulator 13, ICs 124, and discrete logic 123, respectively. The emulator 13 is an additional emulator that may be an emulator of any kind, including the same kind of the present invention.

The processing engine 101 performs the internal logic functions of a target logic, such as signal processing, modulation/demodulation, or encryption/decryption depending on the application of the target chip. The pin signal generator (PSG) 102 has one or more programmable devices, such as field-programmable gate arrays (FPGAs) or programmable logic devices (PLDs), which can be configured to interface with other ICs 124 and discrete logic 123 on the target system 12. Once configured, they generate read/write/control signals to the target system. The processing engine 101 and the PSG 102 communicate with each other through a channel 15 based on any conventional or proprietary communication mechanism such as PCI bus or AGP (accelerated graphics port).

The pin signals generated by the PSG 102 are applied to the socket 121 of the target system 12. Since the pin configuration of the socket 121 is dictated by the target system, a socket adaptor 16 (not explicitly shown in the Fig. 1) may be used to connect the pins of the PSG 102 to the corresponding pins of the socket 121.

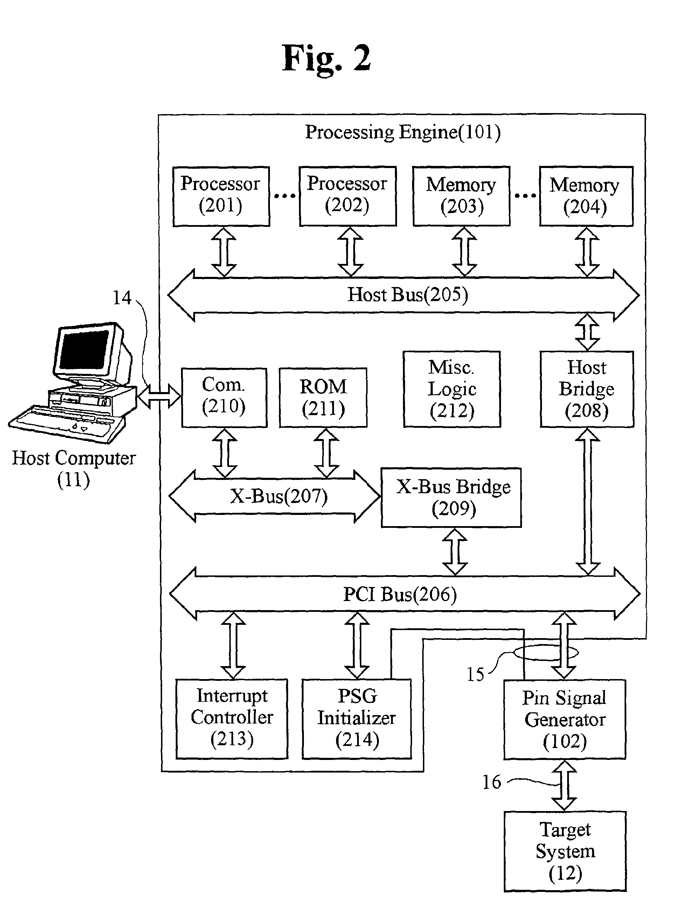

Fig. 2 is a detailed block diagram of a preferred embodiment of the processing engine (PE) 101 of the present invention. The PE includes one or more processors 201, 202 for executing the compiled code, one or more memories 203, 204 for storing a downloaded compiled code and temporary data while executing the compiled code. The PE also includes a host bus 205 for connecting the processors and memories. A compiled code is downloaded from a host computer 11 to the memories 203, 204 through a communication port 14.

The PE 101 further includes a PSG initializer 214, which configures the FPGAs or PLDs of the PSG 102 such that they can function as at least one external interface to the target system 12. The PE further includes an interrupt controller 213 that receives interrupt requests from other blocks in the processing engine, including the PSG 102, to resolve contention of the requests. A PCI bus 206 connects PCI blocks including the PSG initializer and the interrupt controller. The PE further includes miscellaneous logic 212, which includes a clock generator, power regulator, etc.

A host bridge 208 connects the host bus 205 to the processors 201, 202, the memories 203, 204 and the PCI bus 206. An X-bus bridge 209 connects the PCI bus 206 to an X-bus 207, where the X-Bus can be an industry standard bus such as ISA bus. The system ROM 211 stores initialization or booting codes for all hardware components in the PE 101. A communication device 210 providing the communication port 14 enables the PE 101 to communicate with the host computer 11. The communication device can be any conventional device, for example, a universal asynchronous receiver and transmitter (UART), universal serial bus (USB), or parallel communication device.

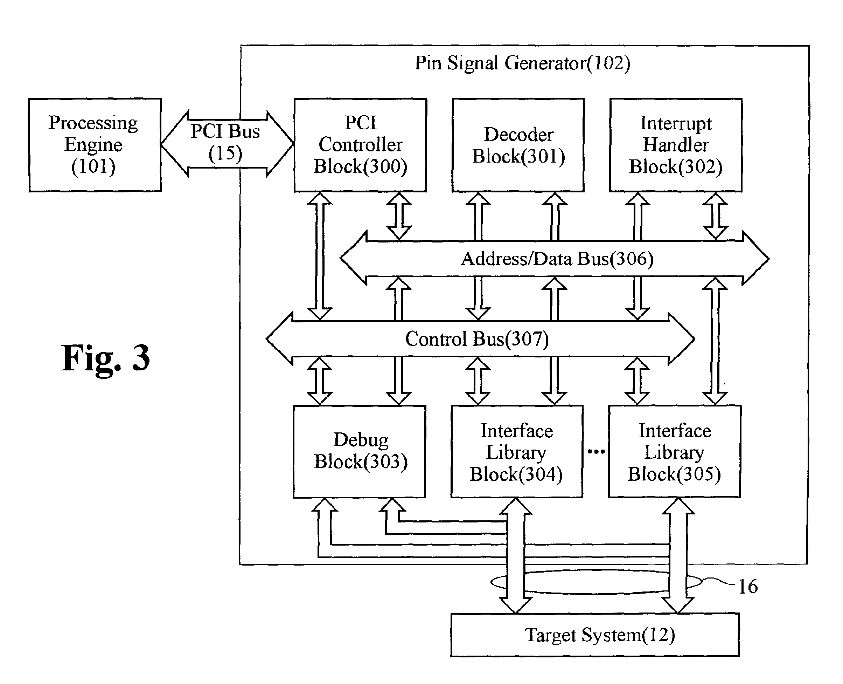

Fig. 3 illustrates an implementation of the pin signal generator (PSG) 102, where the channel 15 between the processing engine 101 and the PSG 102 is a PCI bus. Once configured by the PSG initializer 214, the PSG 102 will be comprised of a PCI controller block 300, a decoder block 301, an interrupt handler block 302, a debug block 303, and one or more interface library blocks 304, 305. The PCI controller block 300 controls the PCI bus 206 through which data is exchanged between the processing engine 101 and the other PSG blocks 301, 302, 303, 304, 305, which are connected to address/data bus 306 and the control bus 307.

When the processing engine 101 needs to read/store data from/to the PSG 102, it uses a standard PCI protocol to address the PSG blocks 301, 302, 303, 304, 305. The PCI controller block 300 monitors whether an address on the PCI bus 206 is for one of the PSG blocks. If so, further determination of which block is addressed is performed by the decoder block 301 based on a predefined address map. Once a block is selected by the address, data from the processing engine 101 is sent to the selected block through the PCI bus 206.

The debug block 303 stores input/output (I/O) signals of the interface library blocks 304, 305 for the purpose of debugging the software model of the chip written in C/C++ and/or the hardware in the target system. The interrupt handler block 302 is used for a plurality of competing blocks 303, 304, 305 in the PSG 102 to communicate effectively with the processing engine 101. The interface library blocks 304, 305 are configured in accordance with at least one external interface models and generates actual pin signals needed to interface with the target system 12.

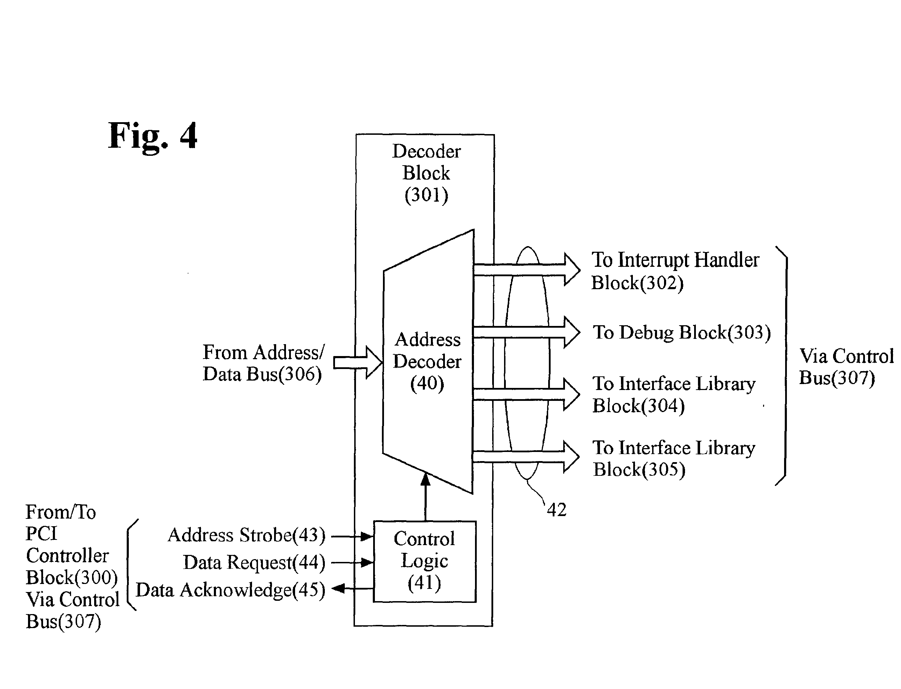

Fig. 4 shows an implementation of the decoder block 301 that includes an address decoder 40 and a control logic 41. The address decoder 40 receives address input signals through the address/data bus 306 and generates control signals 42 to the corresponding blocks in the PSG 102. The control logic 41 receives control signals (shown as address strobe 43, data request 44) through the control bus 307, controls the address decoder 40, and generates a data acknowledge signal 45.

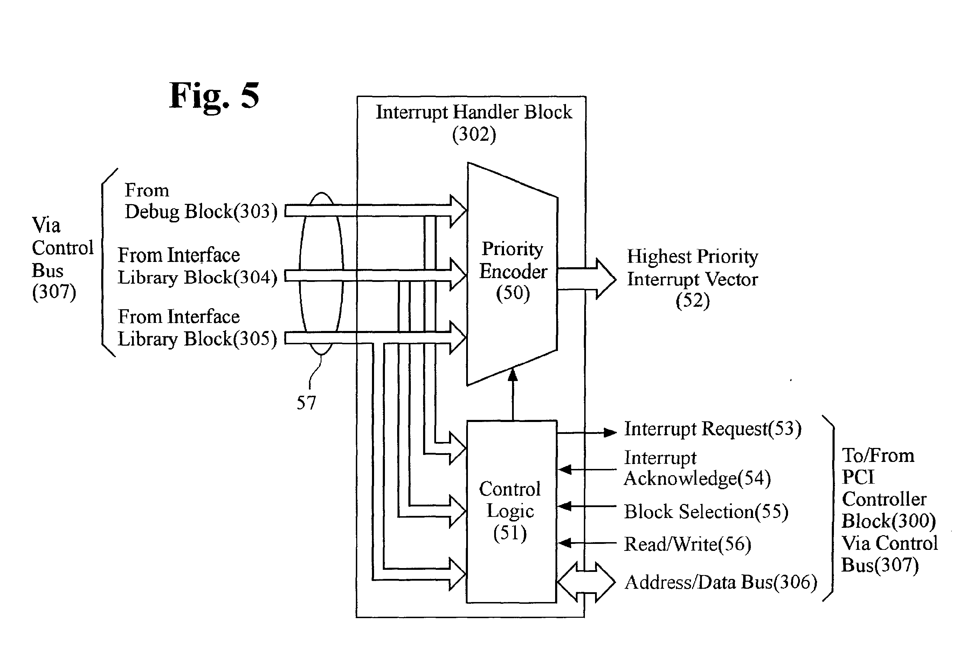

Fig. 5 shows an implementation of the interrupt handler block 302 that receives status information 57 from the debug block 303 and the interface library blocks 304, 305. The interrupt handler generates an interrupt request 53 and interrupt vectors 52 to the interrupt controller 213 (shown in Fig.2) located in the processing engine 101 through the PCI controller block 300 (shown in Fig.3) after selecting one of the interrupt vectors.

The example shows a simple embodiment of using a priority encoder 50 that selects the highest priority interrupt vector 52 from multiple requests 57. Although the example shows a fixed priority mechanism, those skilled in the art will appreciate that any priority selection mechanisms can be adopted such as round-robin or fairness-based priority. The control logic 51 controls the priority encoder 50 and generates the interrupt request 53 and receives the interrupt acknowledge 54.

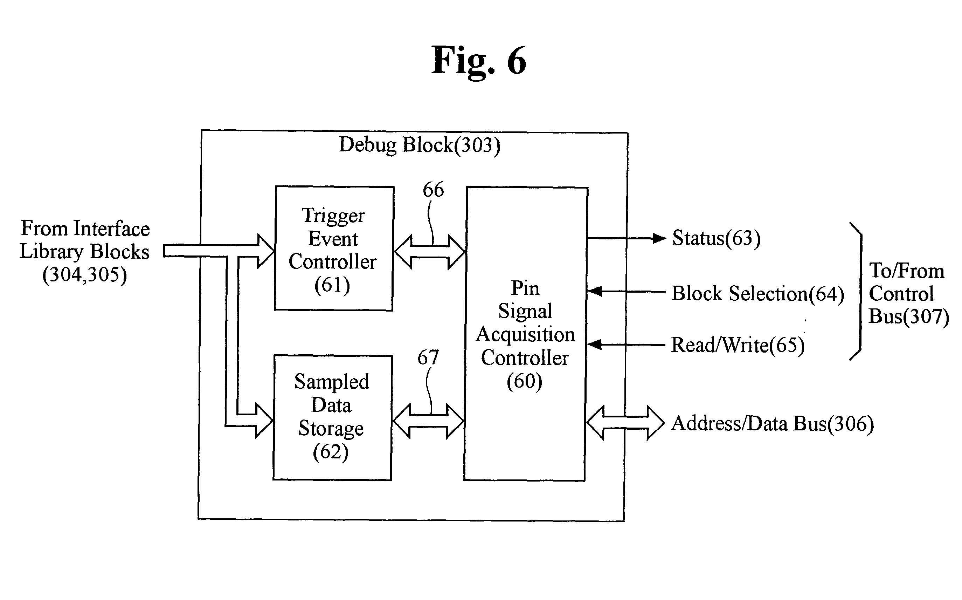

Fig. 6 is an example of the debug block 303 that samples I/O signals of the interface library blocks 304, 305 and stores them to a sampled data storage 62, which could be implemented as a memory, circular queue type storage, or any type of storage. A pin signal acquisition controller 60 controls a trigger event controller 61 and the sampled data storage 62 through connections 66, 67, respectively. The trigger event controller 61 is configured by the pin signal acquisition controller 60, for control by the processor 201, 202, to generate a trigger event signal when one of the predefined signal patterns or combination of these signals occurs. Once the trigger event signal is generated, the pin signal acquisition controller 60 stops the sampled data storage 62 from saving sampled data, and reports its status to the interrupt handler block 302 through a status signal 63. Eventually, the sampled data stored in the sampled data storage 62 is used by a pin signal analyzer that monitors I/O signals and software variables.

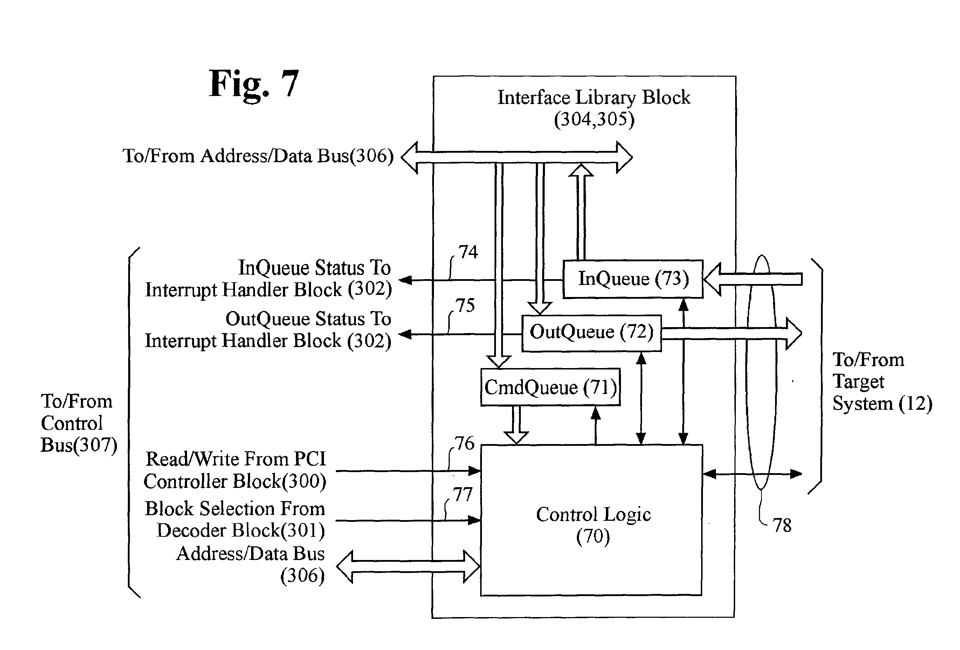

Fig. 7 illustrates an implementation of the interface library blocks 304, 305, each of which is an interface with pins in the target system 12. The interface control command and output data from the PE 101 through the PCI bus 15 and the PCI controller block 300 are stored in the CmdQueue 71 and OutQueue 72, respectively. Pin signals 78 are generated according to a sequence of control signals by the control logic 70. The input signals from the target system 12 are stored in the InQueue 73 and eventually transferred to the processing engine 101. The InQueue status 74 and the OutQueue status 75 represent the state of the corresponding buffers and are connected to the interrupt handler block 302 via the control bus 307.

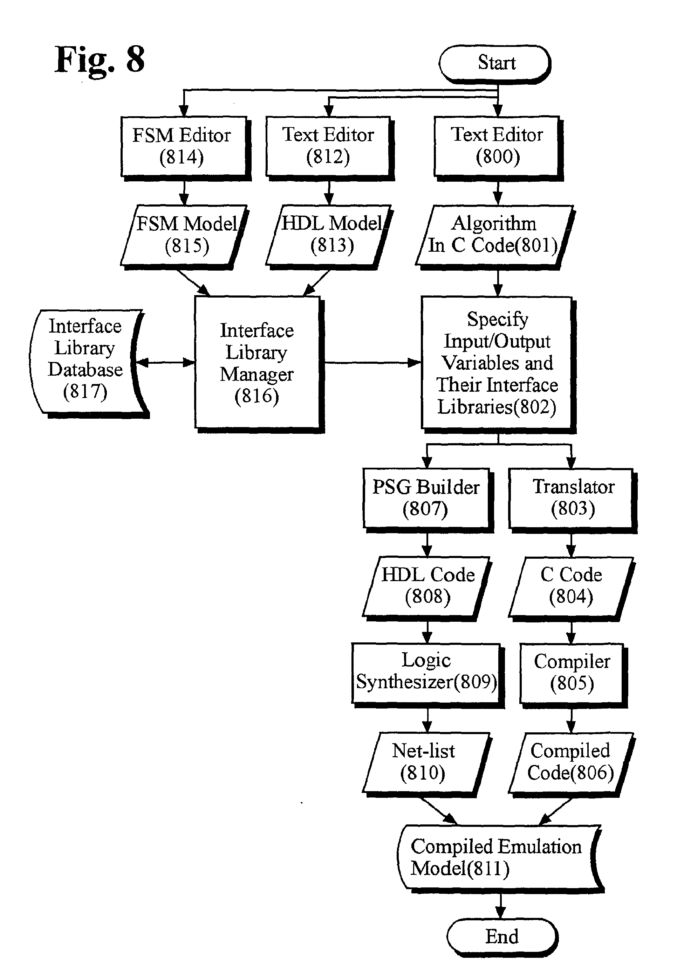

Fig. 8 is a flow diagram illustrating the steps leading to the completion of a compiled emulation model according to the preferred embodiment of the invention.

For a program describing the logic function of a chip being designed to interact with real hardware in the target system, an appropriate set of interface functions are needed. These interface functions communicate with the program and interact with the hardware in accordance with predefined specifications that set forth how to generate and receive pin signals to and from the hardware in the target system. Those variables in the program that represent a gateway to the hardware are called input/output (I/O) variables. A hardware implementation that communicates with the interface function is called the interface library.

Modeling of an algorithm to be performed by a chip, described in a high-level programming language, does not distinguish whether data to be processed is inputted/outputted to/from external devices, because the algorithm itself is not concerned with the sources or destinations of data it handles. Moreover, the interface specification, a manner of interaction with external devices/circuits, is actually independent of an algorithm representing the internal functions of a chip. Therefore, the present invention allows a user to designate the relevant part of the high-level programming language program that involves communication with external devices in terms of the I/O variables. This step is called an insertion of an application programming interface (API).

The interface information in terms of I/O variables includes one or more of the I/O protocol, read bus cycle, write bus cycle, and a base address indicating a memory location when the protocol requires an address bus. With this information, the I/O variables are converted to respective I/O functions that eventually connect to the interface library. An I/O function is generated for each interface of the chip.

For example, if an I/O variable "*a*" needs to be read, a protocol that was assigned to "*a*" is used to read data from the target system as follows: "*data = a* + *b*" is converted to "*data = io_read(PORT_A) + b*" while "*a = data*" is converted to "*io_write(PORT_A, data).*" Here "*a*" is an I/O variable and both "*io_read()*" and "*io_write()*" are I/O functions. With this conversion scheme, an access to a variable becomes an execution of the corresponding function.

While the API program replaces I/O variables with I/O functions, a driver builder generates code of the I/O functions and prepares additional functions such as multi-threading for supporting concurrency features of I/O functions.

The I/O variables are each assigned a port (also called interface library) unique to the PSG 102 ("*PORT_A*" as mentioned above) in order to inform the PSG 102 of a protocol to be followed. In other words, accessing the I/O variables leads to the activation of one or more pins of the emulated chip. The access pattern of an I/O variable determines the direction of the I/O, i.e., a read access means the data need to be transferred by an input interface protocol and a write access indicates the data to be outputted to a component in the target system.

The interface model is transformed to an HDL-based hardware model, which is subsequently synthesized or mapped to the PLD in the PSG 102 as explained above in connection with the structure of the PSG 102.

First, the algorithm 801 of a logic function to be embodied in a target chip is developed by describing it in a high-level programming language, such as C/C++ or its equivalent, using a conventional text editor 800. The high-level programming language could also be a variant of C such as SystemC or SpecC. Interface libraries are prepared by describing them in a hardware description language (HDL) code 813 if the external interface is for a standard external device. For a user-defined standard, a finite state machine (FSM) model 815 using a conventional text editor 812 or FSM editor 414 is used to describe the behavior of the interface. Since the target chip exchanges data or signals with possibly many other parts of the target system 12 once it is installed on the target system 12, many interface libraries are needed to allow data exchange in mutually-agreed protocols. Once these interface libraries are completed, they are registered in an interface library database 817 by an interface library manager 816.

Second, the I/O variables and their corresponding interface libraries are specified and decided in step 802.

Third, a translator 803 converts the algorithm in C code 801 into a modified C code 804 such that it includes interface functions specified in step 802.

Fourth, the modified C code 804 is compiled by a C compiler 805 in the host computer 11 into a compiled code 806 that will be executed by the processing engine 102 in the emulator 10.

In parallel with these steps, interface libraries selected in step 802 specified in HDL code 808 are generated by the PSG builder 807. The HDL code 808 is subsequently synthesized into a net-list 810 by the logic synthesizer 809 to be mapped into PLDs or FPGAs in the PSG 102.

As described above, the present invention enables fast and effective emulation of a chip design by generating appropriate pin signals required by external interfaces. The present invention, by allowing the emulation of a chip design to be performed during the very early stage of the design, significantly reduces the chip design and system development time. The present invention has been successfully applied to verify several chip designs in various applications, such as an MPEG2 video decoder, an MP3 decoder, and a wireless modem.

While the invention has been described with reference to preferred embodiments, it is not intended to be limited to those embodiments. It can be easily appreciated by those skilled in the art that many modifications can be made to the structure of the described embodiments without departing from the scope of the invention.

## Claims

1. An in-circuit emulation apparatus for verifying a chip design that is partitioned into an internal logic design and an external interface design to communicate with a target system according to at least one interface protocol, comprising:
a processing engine (PE) for processing a core algorithm according to the internal logic design; and
a pin signal generator (PSG) for generating pin signals according to the external interface design.

2. The apparatus of Claim 1, wherein said PE comprises at lease one microprocessor.

3. The apparatus of Claim 1, wherein said PE further comprises means for communicating with a host computer.

4. The apparatus of Claim 1, wherein said PE comprises a PSG initializer for configuring the PSG.

5. The apparatus of Claim 1, wherein said PSG is implemented using field programmable gate arrays (FPGAs).

6. The apparatus of Claim 1, wherein said PSG is implemented using programmable logic devices (PLDs).

7. The apparatus of Claim 1, wherein said at least one interface protocol includes a standard interface protocol.

8. The apparatus of Claim 1, wherein said at least one interface protocol includes a user-defined protocol.

9. The apparatus of Claim 8, wherein the PSG includes a finite state machine (FSM) for registering the user-defined protocol.

10. The apparatus of Claim 1, wherein the communication between the PE and the PSG is by control packets.

11. The apparatus of Claim 1, further comprising a bus between the PE and the PSG for exchanging interface control packets.

12. The apparatus of Claim 1, wherein said PSG comprises;
a controller block for communicating with said PE; and
an address decoder block for selecting one of blocks in said PSG; and
an interrupt handler block for selecting one out of multiple interrupt requests from said blocks of said PSG; and
an interface library block for each of said external interface design required for sending and receiving pin signals to and from external circuits in said target system; and
a debug block for storing both internal and external signals of said PSG.

13. A method of verifying a chip design through in-circuit emulation, comprising the steps of:
partitioning the chip design into an internal logic design for a core algorithm and an external interface design for an interface protocol;
specifying the interface protocol using a hardware description language (HDL);
specifying the core algorithm using a high-level programming language;
programming programmable logic devices according to the specified interface protocol to generate appropriate pin signals; and
programming a microprocessor to run the core algorithm.

14. The method of Claim 13, wherein the HDL is VHDL.

15. The method of Claim 13, wherein the HDL is Verilog.

16. The method of Claim 13, wherein the high-level programming language is C.

17. The method of Claim 13 wherein the high-level programming language is C++.

18. The method of Claim 13 wherein the high-level programming language is SystemC.

19. The method of Claim 13 wherein the high-level programming language is SpecC.

20. A method for verifying a chip design that is partitioned into an internal logic design and an external interface design in conjunction with a target system, comprising the steps of:
modeling the internal logic design using a high-level programming language;
modeling the external interface design using a hardware description language (HDL);
modeling an external interface protocol using a finite state machine (FSM) editor;
managing interface libraries of said external interface protocol under control of interface library manager program;
defining input and output variables that are software variables to read from or write to said target system; and
converting said input and output variables to respective input and output functions that read from and write to said target system.

21. A computer-readable storage medium for storing an emulator program for verifying a chip design partitioned into an internal logic design for running a core algorithm and an external interface design for communicating with a target system, wherein the program comprises:
an application programming interface (API) builder for inserting an interface code to the core algorithm;
a driver builder for generating the interface code using a thread that can be independently executed from the core algorithm; and
a pin signal generator (PSG) builder for generating a code for configuring reconfigurable hardware to generate required pin signals for the external interface design.

22. The storage medium of Claim 21, wherein the API builder uses I/O variables to translate them into I/O functions.

23. The storage medium of Claim 21, wherein the storage medium is a compact disk (CD).

24. The storage medium of Claim 21, wherein the storage medium is a hard disk.

25. An in-circuit emulation system for verifying the design of a chip to be used in a target system, comprising:
a host computer for compiling a software model of the chip to generate a compiled code; and
an emulator that interacts with the target system by downloading the compiled code from the host computer,
wherein the software model is described in a high-level programming language.

26. The system of Claim 25, wherein the emulator further comprises:
a processing engine for executing the compiled code; and
a pin signal generator for generating pin signals needed to interface with the target system.

27. The system of Claim 26, wherein the pin signal generator is configured as a number of functional blocks.

28. The system of Claim 25, wherein the emulator further comprises:
a pin signal analyzer for monitoring and debugging of pin signals and software variables.
